# EUROPEAN PATENT APPLICATION

(11) **EP 3 306 695 A1**
(43) Date of publication of application: **11.04.2018**
(21) Application number: 15856171.2
(22) Date of filing: 21.09.2015
(51) Int. Cl.: H01L 51/52, H01L 51/54, H01L 51/56

(54) **DOUBLY-LAYERED DOPED PHOSPHORESCENT LIGHT EMITTING DEVICE AND PREPARATION METHOD THEREFOR**

(30) Priority: 26.05.2015 CN 201510276057
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: CHEN, Lei, Beijing 100176 (CN); ZHANG, Xiaojin, Beijing 100176 (CN); LAI, Weilin, Beijing 100176 (CN)
(74) Representative: Brötz, Helmut
(86) International application number: PCT/CN2015/090098
(87) International publication number: WO 2016/187995

(57) **Abstract**

A double-layer doped phosphorescent light emitting device and a fabrication method thereof are provided, and the double-layer doped phosphorescent light emitting device comprises a light emitting double-layer (13), wherein the light emitting double-layer comprises a first light emitting layer (131) and a second light emitting layer (132), the first light emitting layer and the second light emitting layer each comprise a host material and a guest material, the host material of the first light emitting layer (131) is a hole type host material and the host material of the second light emitting layer (132) is an electron type host material.

## Description

### TECHNICAL FIELD

At least one embodiment of the present disclosure relate to a double-layer doped phosphorescent light emitting device and a fabrication method thereof.

### BACKGROUND

In recent years, an organic light emitting display (OLED) as a new generation of displaying technology has attracted much attention. Especially, the continuous improvement and perfection of a fabrication process of an organic electroluminescence (EL) device, a mass production of a full color organic EL display, a huge commercial prospect of the organic electroluminescence (EL) device has gradually revealed. With the appearance of the full color organic EL display, display has become an increasingly demanding by customers. Especially the light emitting efficiency and the color purity of a RGB with three colors are the emphasis and difficulty of the research.

In order to improve the efficiency, at present, a red light emitting unit (R) and a green light emitting unit (G) in an active matrix organic light emitting diode (AMOLED) usually use a phosphorescent doped light emitting mechanism. The host material of the phosphorescent doped light emitting mechanism required a higher yield of excitons and a good charge transport properties, a strong chemical properties and thermal stability, a high glass transition temperature(>120°C). It is necessary to consider whether the host material of the phosphorescent doped light emitting mechanism is matched with the T1 state energy level of the guest material. A blue band gap material is usually used as a host of R, G and B, and the level matching also need to be considered for better energy conversion.

At present, the host of a doping mechanism is divided into a single host doping and a co-host doping. The requirement of a single host doping process is low and the preparation is simple. Whether a carrier is balance or not is controlled by the carrier transport properties of a host material to a large extent, the hole electron transmission of most of the materials is imbalance, which result in the light emitting center deviates from the central of the light-emitting layer (EML) and the exciton diffuses to the surface causing excitons quenching. A co-host doping includes an independent co-host doping and a pre-mix co-host doping. An independent co-host doping is a method of three sources of evaporation for fabricating a light-emitting layer by adding a phosphorescent dopant to the two kinds of host materials of hole type and electron type. Its advantage is that compared with the single host, the transport of the carrier can be balanced by adding two kinds of transmission performance hosts to make the light-emitting center close to the center of the light-emitting layer. But the performance of the independent co-host doping system device is limited by the doping proportion of the two kinds of hosts. The change of doping ratio has a great effect on the efficiency of the device. Therefore, the stability requirement of an evaporation process is higher. In addition, after the two kinds of host mixing they may also interact with each other to form an exciplex and the exciplex causes the quenching of the host excitons, and the performance of the device is declined. The co-host doping of pre-mixing is the two kinds of host materials mixed well firstly, and then put into the crucible for evaporation, which requires the vapor deposition temperatures of the two host materials are extremely similar to ensure that the mixing ratio of the two kinds of host materials is unchanged. It is very difficult to develop and find a co-host material having a same evaporation temperature and a superior performance, therefore the structure designing and the performance optimizing of the device are greatly limited. Both a single host doping and a co-host doping (including an independent co-host doping and a pre-mixed co-host doping) are very difficult to control the recombination of the excitons and the diffusion center in the center of the light emitting layer, therefore, at present, an electron-blocking layer (EBL) is usually added. However, the addition of the electron-blocking layer not only increases the driving voltage, but also makes the design and fabrication of the devices become more complicated.

### SUMMARY

At least one embodiment of the present disclosure provides a double-layer doped phosphorescent light emitting device and a fabrication method thereof. The double-layer doped phosphorescent light emitting device comprises a light emitting double-layer, the problem of poor repeatability of the device caused by the fluctuation of the doping ratio of an independent co-host doping during the triple-source co-evaporation can be solved, and the limitation of the material selection in the pre-mixed double-host doping is avoided.

At least one embodiment of the present disclosure provides a double-layer doped phosphorescent light emitting device and the double-layer doped phosphorescent light emitting device comprises a light emitting double-layer, wherein the light emitting double-layer comprises a first light emitting layer and a second light emitting layer, the first light emitting layer and the second light emitting layer each comprise a host material and a guest material, the host material of the first light emitting layer is a hole type host material and the host material of the second light emitting layer is an electron type host material.

For example, in the double-layer doped phosphorescent light emitting device, a thickness of the first light emitting layer is determined by a hole mobility of the hole type host material, a thickness of the second light emitting layer is determined by an electron mobility of the electron type host material.

For example, in the double-layer doped phosphorescent light emitting device, the thickness of the first light emitting layer and the thickness of the second light emitting layer are different.

For example, in the double-layer doped phosphorescent light emitting device, a total thickness of the first light emitting layer and the second light emitting layer is from 20 to 40nm.

For example, the double-layer doped phosphorescent light emitting device further comprises a hole transport layer, wherein the hole type host material is different from a hole transport material of the hole transport layer.

For example, in the double-layer doped phosphorescent light emitting device, the host material of the first light emitting layer comprises a material containing carbazole group, and the material containing carbazole group comprises any one of 4,4'-Bis(N-carbazolyl)-1,1'-biphenyl (CBP), 4,4',4"-Tris(carbazol-9-yl)triphenylamine (TCTA) and 9,9-(1,3-Phenylene)bis-9H-carbazole (mCP), the hole transport material comprises any one of N,N'-bis(1-naphthyl)-N,N'-biphenyl-1,1'- biphenyl-4,4'-diamine (NPB), 4,4',4'-Tris(N-3-methylphenyl-N-phenyl-amino)-triphenylamine (m-MTDATA), or 4,4'-bis [N-(4-carbazolylphenyl)-N-phenylamino] biphenyl (CPB).

For example, the double-layer doped phosphorescent light emitting device further comprises an electron transport layer, wherein the electron type host material is different from an electron transport material of the electron transport layer.

For example, in the double-layer doped phosphorescent light emitting device, the host material of the second light emitting layer comprises any one of aluminum (III) bis(2-methyl-8-quninolinato)-4-phenylphenolate (BAlq), 2,4,6-tri(9H-carbazol-9-yl)-1,3,5-triazine (TRZ) and 2,7-bis(diphenyl phosphine oxide)-9,9-dimethylfluorene (PO6), and the electron transport material comprises any one of 4,7-diphenyl-1,10-phenanthroline(BPhen), 1,3,5-Tris(1-phenyl-1H-benzimidazol-2-yl)benzene (TPBI) , or n-type doped electron transport material.

For example, in the double-layer doped phosphorescent light emitting device, the guest material of the first light emitting layer and the guest material of the second light emitting layer are a same phosphorescent dopant, and the phosphorescent dopant comprises any one of a red phosphorescent material and a green phosphorescent material.

For example, in the double-layer doped phosphorescent light emitting device, the red phosphorescent material comprises any one of platinum (II) octaethyl porphyrin (PtOEP), Bis[2-(2'-benzothienyl)pyridinato-N,C3'](acetylacetonato)iridium [(btp)₂Ir(acac)], Tris(dibenzoylmethane) mono(1,10-phenanthroline)europium(III) [Eu(dbm)₃(Phen)], Tris[1-phenylisoquinoline-C2,N] iridium(III) (Ir(piq)₃), or Bis(1-phenylisoquinoline)(acetylacetonate)iridium(III) [Ir(piq)₂(acac)];

the green phosphorescent material comprises any one of Tris[1-phenylisoquinoline-C2,N] iridium(III) (Ir(piq)₃), acetylacetonato bis(2-phenylpyridine) Iridium [Ir(ppy)₂(acac)], Tris-(3-methyl-2-phenylpyridine) iridium (Ir(mppy)3), acetylacetonato bis(2-(4-fluorophenyl)-4 -phenylpyridine) Iridium [Ir(FPP)₂(acac)], or tri(4-tert-butyl-2-phenylpyridine) Iridium (Ir (Bu-ppy)₃).

At least one embodiment of the present disclosure further provides a fabrication method of a double-layer doped phosphorescent light emitting device, and the fabrication method comprises forming a light emitting double-layer, wherein the forming of the light emitting double-layer comprises forming a first light emitting layer and forming a second light emitting layer, the first light emitting layer and the second light emitting layer each comprise a host material and an guest material, the host material of the first light emitting layer is a hole type host material and the host material of the second light emitting layer is an electron type host material.

For example, in the fabrication method of the double-layer doped phosphorescent light emitting device, both the first light emitting layer and the second light emitting layer are formed by double-sources co-evaporation.

For example, in the fabrication method of the double-layer doped phosphorescent light emitting device, a thickness of the first light emitting layer and a thickness of the second light emitting layer are determined by a hole mobility of the hole type host material and an electron mobility of the electron type host material respectively.

For example, in the fabrication method of the double-layer doped phosphorescent light emitting device, excitons recombine at an interface of the first light emitting layer and the second light emitting layer by adjusting the thickness of the first light emitting layer and the thickness of the second light emitting layer.

For example, the fabrication method of the double-layer doped phosphorescent light emitting device further comprises forming a hole transport layer, wherein the hole type host material is different from a hole transport material of the hole transport layer.

For example, in the fabrication method of the double-layer doped phosphorescent light emitting device, the host material of the first light emitting layer comprises a material containing carbazole group, and the material containing carbazole group comprises any one of 4,4'-Bis(N-carbazolyl)-1,1-biphenyl (CBP), 4,4',4"-Tris(carbazol-9-yl)triphenylamine (TCTA) and 9,9-(1,3-Phenylene)bis-9H-carbazole (mCP), the hole transport material comprises any one of N,N'-bis(1-naphthyl)-N,N'-biphenyl-1,1'- biphenyl-4,4'-diamine (NPB), 4,4',4'-Tris(N-3-methylphenyl-N-phenyl-amino)-triphenylamine (m-MTDATA) , or 4,4'-bis [N-(4-carbazolylphenyl)-N-phenylamino] biphenyl (CPB).

For example, the fabrication method of the double-layer doped phosphorescent light emitting device further comprises forming an electron transport layer, wherein the electron type host material is different from an electron transport material of the electron transport layer.

For example, in the fabrication method of the double-layer doped phosphorescent light emitting device, the host material of the second light emitting layer comprises any one of aluminum (III) bis(2-methyl-8-quninolinato)-4-phenylphenolate (BAlq), 2,4,6-tri(9H-carbazol-9-yl)-1,3,5-triazine (TRZ) and 2,7-bis(diphenyl phosphine oxide)-9,9-dimethylfluorene (PO6), and the electron transport material comprises any one of 4,7-diphenyl-1,10-phenanthroline(BPhen), 1,3,5-Tris(1-phenyl- 1H-benzimidazol-2-yl)benzene (TPBI), or n-type doped electron transport material.

For example, in the fabrication method of the double-layer doped phosphorescent light emitting device, the guest material of the first light emitting layer and the guest material of the second light emitting layer are a same phosphorescent dopant, and the phosphorescent dopant comprises any one of a red phosphorescent material and a green phosphorescent material.

For example, in the fabrication method of the double-layer doped phosphorescent light emitting device, the red phosphorescent material comprises any one of platinum (II) octaethyl porphyrin (PtOEP), Bis[2-(2'-benzothienyl)pyridinato-N,C3'](acetylacetonato)iridium [(btp)₂Ir(acac)], Tris(dibenzoylmethane) mono(1,10-phenanthroline)europium(III) [Eu(dbm)₃(Phen)], Tris[1-phenylisoquinoline-C2,N] iridium(III) (Ir(piq)₃), or Bis(1-phenylisoquinoline)(acetylacetonate)iridium(III) [Ir(piq)₂(acac)]; and the green phosphorescent material comprises any one of Tris[1-phenylisoquinoline-C2,N] iridium(III) (Ir(piq)₃), acetylacetonato bis(2-phenylpyridine) Iridium [Ir(ppy)₂(acac)], Tris-(3-methyl-2-phenylpyridine) iridium (Ir(mppy)3), acetylacetonato bis(2-(4-fluorophenyl)-4 -phenylpyridine) Iridium [Ir(FPP)₂(acac)], or tri(4-tert-butyl-2-phenylpyridine) Iridium (Ir (Bu-ppy)₃).

### BRIEF DESCRIPTION OF THE DRAWINGS

In order to clearly illustrate the technical solution of the embodiments of the disclosure, the drawings of the embodiments will be briefly described in the following, it is obvious that the described drawings are only related to some embodiments of the disclosure and thus are not limitative of the disclosure.
Fig. 1 shows a schematic view of a structure of a double-layer doped phosphorescent light emitting device (a normal structure) provided by an embodiment of the present disclosure;
Fig. 2 shows a schematic view of a structure of a double-layer doped phosphorescent light emitting device (an inverted structure) provided by another embodiment of the present disclosure; and
Fig. 3 shows a schematic view of a structure of a double-layer doped phosphorescent light emitting device (a transparent structure) provided by another embodiment of the present disclosure;

### Description of the reference numerals:

10-glass substrate; 11- hole transport layer (HTL); 12-electron transport layer(ETL); 13- light emitting double-layer; 131- first light emitting layer;132- second light emitting layer; 14- cathode; 15- anode; 16- hole injection layer (HIL); 17- protective layer.

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

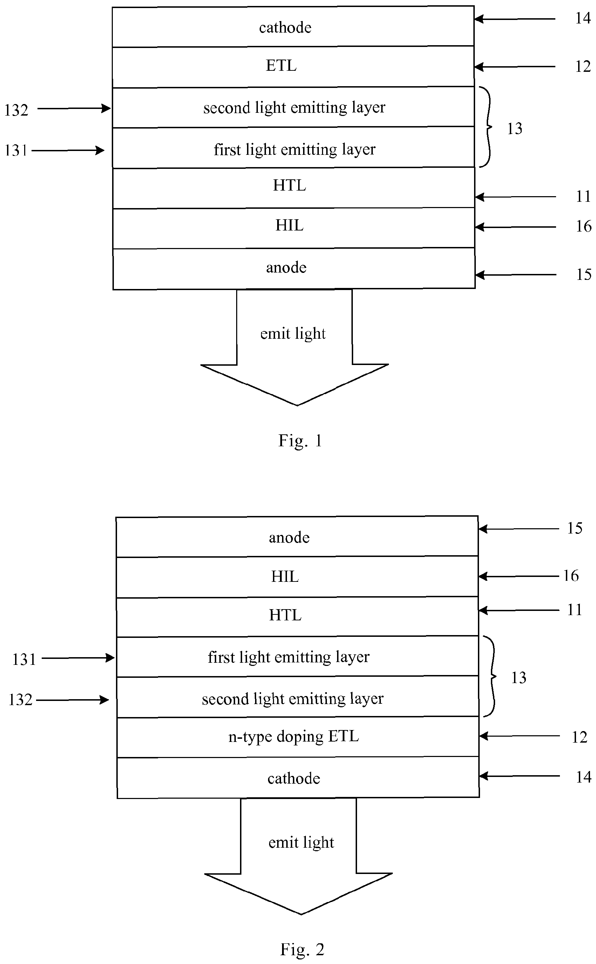

At least one embodiment of the present disclosure provides a double-layer doped phosphorescent light emitting device, as shown in Fig. 1, the double-layer doped phosphorescent light emitting device includes a light emitting double-layer 13, wherein the light emitting double-layer 13 includes a first light emitting layer 131 and a second light emitting layer 132, both the first light emitting layer 131 and the second light emitting layer 132 include a host material and a guest material, the host material of the first light emitting layer 131 is a hole type host material and the host material of the second light emitting layer 132 is an electron type host material.

A light emitting double-layer is set to make the diffusion scale of excitons in the region of two light-emitting layers and to avoid the quenching caused by excitons diffusing to other layers, and to save the usage of electron blocking layer. And the first light emitting layer and the second light emitting layer are formed by double-sources co-evaporation respectively, thereby the problem of poor repeatability of the device caused by the fluctuation of the doping ratio of an independent co-host doping during the triple-source co-evaporation can be solved, and the limitation of the material selection in the pre-mixed double-host doping is avoided.

For example, a thickness of the first light emitting layer is determined by a hole mobility of the hole type host material, a thickness of the second light emitting layer is determined by an electron mobility of the electron type host material. For example, the thickness of the first light emitting layer 131 and the thickness of the second light emitting layer 132 can be adjusted according to the hole mobility of the hole type host material and the electron mobility of the electron type host material respectively. For example, in the case that the hole mobility of the hole type host material is higher, the first light emitting layer with larger thickness is adopted accordingly, if the hole mobility of the hole type host material is lower, the first light emitting layer with smaller thickness is adopted accordingly. The thickness of the second light emitting layer can also be adjusted in a similar way. In the case that the electron mobility of the electron type host material is higher, the second light emitting layer with larger thickness is adopted accordingly, if the electron mobility of the electron type host material is lower, the second light emitting layer with smaller thickness is adopted accordingly. For example, the thickness of the first light emitting layer 131 and the thickness of the second light emitting layer 132 are usually different. The recombination center of the excitons is located in the interface area of the first light emitting layer 131 and the second light emitting layer 132 by adjusting the thickness of the first light emitting layer 131 and the thickness of the second light emitting layer 132, to ensure that the diffusion scale of excitons is in the region of two light-emitting layers and to avoid the quenching caused by excitons diffusing to other layers, and to save the usage of an electron blocking layer.

For example, the total thickness of the first light emitting layer 131 and the second light emitting layer 132 is from about 20 to about 40nm.

For example, the transportation of the carrier can be controlled by adjusting the thicknesses of the two light-emitting layers respectively of the double-layer doped phosphorescent light emitting device, thus ensure that the diffusion scale of excitons is in the region of two light-emitting layers and to avoid the quenching caused by excitons diffusing to other layers, and to omit the electron blocking layer.

For example, the double-layer doped phosphorescent light emitting device further comprises a hole transport layer 11, and the hole type host material is different from a hole transport material of the hole transport layer 11(the hole type host material of the first light-emitting layer is different from the hole transport material of the hole transport layer).

If the hole type host material of the first light-emitting layer 131 is different from the hole transport material of the hole transport layer 11, the life of the double-layer doped phosphorescent light emitting device can be optimized, thereby the double-layer doped phosphorescent light emitting device has a longer life.

For example, the double-layer doped phosphorescent light emitting device may further comprises an electron transport layer 12, and the electron type host material is different from an electron transport material of the electron transport layer 12(the electron type host material of the second light-emitting layer is different from the electron transport material of the electron transport layer).

If the electron type host material of the second light-emitting layer 132 is different from the electron transport material of the electron transport layer 12, the life of the double-layer doped phosphorescent light emitting device can be optimized, thereby the double-layer doped phosphorescent light emitting device has a longer life.

For example, the host material of the first light emitting layer includes a material containing a carbazole group, and the material containing a carbazole group comprises any one of 4,4'-Bis(N-carbazolyl)-1,1-biphenyl (CBP), 4,4',4"-Tris(carbazol-9-yl)triphenylamine (TCTA) or 9,9-(1,3-Phenylene)bis-9H-carbazole (mCP), but not limited to this.

For example, the material of the hole transport layer 11 includes any one of N,N'-diphenyl-N,N'-bis(1-naphthyl)-(1,1'-biphenyl)-4,4'-diamine(NPB), 4,4',4'-Tris(N-3-methylphenyl-N-phenyl-amino)-triphenylamine (m-MTDATA) or 4,4'-bis [N-(4-carbazolylphenyl)-N-phenylamino] biphenyl (CPB), but not limited to this, and for example the thickness is about 20-70nm.

For example, the host material of the second light emitting layer 132 includes any one of aluminum (III) bis(2-methyl-8-quninolinato)-4-phenylphenolate (BAlq), 2,4,6-tri(9H-carbazol-9-yl)-1,3,5-triazine (TRZ) or 2,7-bis(diphenyl phosphine oxide)-9,9-dimethylfluorene (PO6), but not limited to this.

For example, the material of the electron transport layer 12 includes any one of 4,7- diphenyl-1,10-phenanthroline(BPhen), 1,3,5-Tris(1-phenyl-1H-benzimidazol-2-yl)benzene (TPBI) and n-type doping electron transport material, but not limited to this, for example the thickness is about 10-30nm. An n-type doped electron transport material for example includes 2,9-dimethyl-4,7-biphenyl-1,10- phenanthroline(BCP): Li₂CO₃, (8-hydroxyquinoline)aluminum(Alq3): Mg, TPBI:Li etc, but not limited to this.

For example, the guest material of the first light emitting layer 131 and the second light emitting layer 132 is a same phosphorescent dopant, thus monochromatic light can be emitted and a monochromatic light emitting device can be formed.

For example, the phosphorescent dopant doping content in the first light emitting layer 131 and the second light emitting layer 132 are less than 10% respectively (mass percent).

For example, the phosphorescent dopant includes any one of a red phosphorescent material and a green phosphorescent material.

For example, the red phosphorescent material includes any one of platinum (II) octaethyl porphyrin (PtOEP), Bis[2-(2'-benzothienyl)pyridinato-N,C3'](acetylacetonato)iridium [(btp)₂Ir(acac)], Tris(dibenzoylmethane) mono(1,10-phenanthroline)europium(III) [Eu(dbm)₃(Phen)], Tris[1-phenylisoquinoline-C2,N] iridium(III) (Ir(piq)₃), or Bis(1-phenylisoquinoline)(acetylacetonate)iridium(III) [Ir(piq)₂(acac)], but not limited to this.

For example, the green phosphorescent material comprises any one of Tris[1-phenylisoquinoline-C2,N] iridium(III) (Ir(piq)₃), acetylacetonato bis(2-phenylpyridine) Iridium [Ir(ppy)₂(acac)], Tris-(3-methyl-2-phenylpyridine) iridium (Ir(mppy)3), acetylacetonato bis(2-(4-fluorophenyl)-4 -phenylpyridine) Iridium [Ir(FPP)₂(acac)], or tri(4-tert-butyl-2-phenylpyridine) Iridium (Ir (Bu-ppy)₃), but not limited to this.

For example, the double-layer doped phosphorescent light emitting device further includes a hole injection layer, a cathode and an anode, and the double-layer doped phosphorescent light emitting device further includes a structure of an electron injection layer, and the structure of the double-layer doped phosphorescent light emitting device can be a normal structure, an inverted structure or a transparent structure.

Fig. 1 shows a double-layer doped phosphorescent light emitting device of a normal structure. The double-layer doped phosphorescent light emitting device comprises a first light emitting layer 131, a second light emitting layer 132, a hole transport layer 11 and an electron transport layer 12, the material of each layer as mentioned above, the double-layer doped phosphorescent light emitting device further includes a cathode 14, an anode 15 and a hole injection layer 16. In the structure, the cathode 14 can be made of a Mg:Ag alloy (Mg-Ag alloy), and its thickness for example is from about 10nm to about 150nm (a suitable thickness can be selected according to the type of the device). The anode 15 can be made of indium tin oxide (ITO), the thickness of the ITO anode for example is from about 10nm to about 150nm. The hole injection layer 16 may comprise a metal oxide MeO, for example MoO₃, it may also comprise a P type doping MeO (metal oxide)-TPD(N,N'- Bis (3- methyl phenyl)-N,N'- diphenyl-1,1'- diphenyl-4,4'- diamine): F4TCNQ(2,3,5,6-tetrafluoro-tetracyanoquinodimethane -7,7,8,8- quinodimethane) or m-MTDATA:F4TCNQ(4,4',4"-Tris(N-3-methylphenyl-N-phenyl-amino)triphenylamine: 2,3,5,6-tetrafluoro-tetracyanoquinodimethane -7,7,8,8- quinodimethane) etc, the thickness for example is from about 1nm to about 30nm.

For example, a double-layer doped green phosphorescent light emitting device of a normal structure: anode ITO 150nm/m-MTDATA:F4TCNQ 30nm/m-MTDATA 60nm/CBP:Ir(ppy)₃ 7% 24nm/BAlq: Ir(ppy)₃ 7% 16nm/BPhen 10nm/Mg:Ag 100nm (cathode).

For example, a double-layer doped red phosphorescent light emitting device of a normal structure: anode ITO 150nm/m-MTDATA:F4TCNQ 30nm/m-MTDATA 60nm/CBP:Ir(ppy)₃ 7% 24nm/BAlq: Ir(ppy)₃ 7% 16nm/BPhen 10nm/Mg:Ag 100nm (cathode).

Fig. 2 shows a double-layer doped phosphorescent light emitting device of an inverted structure. The double-layer doped phosphorescent light emitting device comprises a first light emitting layer 131, a second light emitting layer 132, a hole transport layer 11 and an electron transport layer 12, the material of each layer as mentioned previously. In the present embodiment, the electron transport layer 12 is, but not limited to, an n-type doping electron transport layer. For example, the double-layer doped phosphorescent light emitting device further includes a cathode 14, an anode 15 and a hole injection layer 16. In the structure, the cathode 14 is made of ITO, the anode 15 is made of a Mg:Ag alloy, the material and the thickness of the hole injection layer 16 refers to the double-layer doped phosphorescent light emitting device of a normal structure, and detailed descriptions will be omitted herein.

For example, a double-layer doped green phosphorescent light emitting device of an inverted structure: cathode ITO 150nm/ BCP:Li₂CO₃ 10nm/BAlq: Ir(ppy)₃ 7% 16nm /CBP:Ir(ppy)₃ 7% 24nm/CPB 40nm/MoO₃ 1nm/Mg:Ag 100nm (anode).

For example, a double-layer doped red phosphorescent light emitting device of an inverted structure: cathode ITO 150nm/ BCP:Li₂CO₃ 10nm/BAlq:Ir(piq)₂(acac) 7% 16nm/CBP:Ir(piq)₂(acac) 7% 24nm/NPB 40nm/MoO₃ 1nm/Mg:Ag 100nm (anode).

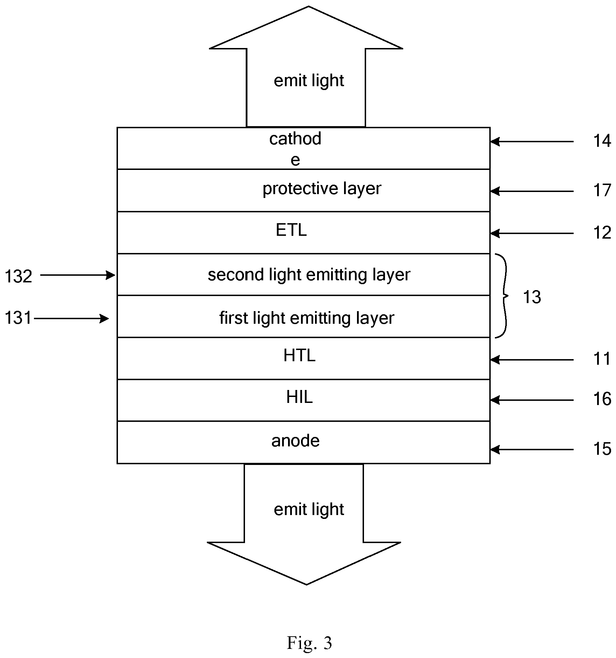

Fig. 3 shows a double-layer doped phosphorescent light emitting device of a transparent structure. The double-layer doped phosphorescent light emitting device comprises a first light emitting layer 131, a second light emitting layer 132, a hole transport layer 11 and an electron transport layer 12, the double-layer doped phosphorescent light emitting device further includes a cathode 14, an anode 15, a hole injection layer 16 and a protective layer 17. The cathode 14 can be made of a Mg:Ag alloy or ITO, the anode 15 can be made of ITO, all the material and the thickness of the host material and the guest material of the hole injection layer 16, the hole transport layer, the electron transport layer, the first light emitting layer and the second light emitting layer are as mentioned above. The protective layer 17, for example, can be made of a metal oxide or a polymer material, wherein the metal oxide for example includes MoO₃, the polymer material for example includes PEDOT:PSS [Polyethylene dioxythiophene- polystyrene sulfonate]. In the case that the cathode 14 is made of a Mg:Ag alloy, the setting of the protective layer 17 is unnecessary.

A fabrication method of a double-layer doped phosphorescent light emitting device is also provided by an embodiment of the present disclosure, and the method includes forming a light emitting double-layer 13, wherein the light emitting double-layer 13 comprises a first light emitting layer 131 and a second light emitting layer 132, both the first light emitting layer 131 and the second light emitting layer 132 include a host material and a guest material, the host material of the first light emitting layer 131 is a hole type host material and the host material of the second light emitting layer 132 is an electron type host material.

A light emitting double-layer is set to make the diffusion scale of excitons in the region of two light-emitting layers and to avoid the quenching caused by excitons diffusing to other layers, and to save the usage of electron blocking layer.

For example, in the method, both the first light emitting layer and the second light emitting layer are formed by double-sources co-evaporation. The fabrication method is simple. The problem of poor repeatability of the device caused by the fluctuation of the doping ratio of an independent co-host doping during the triple-source co-evaporation can be solved, and the limitation of the material selection in the pre-mixed double-host doping is avoided.

For example, the thicknesses of the first light emitting layer 131 and the second light emitting layer 132 can be determined according to the hole mobility of the hole type host material and the electron mobility of the electron type host material respectively.

For example, the recombination area of the excitons is in the interface area of the first light emitting layer 131 and the second light emitting layer 132 by controlling the thickness of the first light emitting layer 131 and the thickness of the second light emitting layer 132.

For example, in the method, the transportation of the carrier can be controlled by adjusting the thicknesses of the two light-emitting layers, thus ensure that the diffusion scale of excitons is in the region of two light-emitting layers and to avoid the quenching caused by excitons diffusing to other layers, and to save the usage of electron blocking layer.

For example, the method further comprises forming a hole transport layer 11, wherein the hole type host material is different from a hole transport material of the hole transport layer 11.

For example, if the hole type host material is different from the hole transport material of the hole transport layer 11, the life of the double-layer doped phosphorescent light emitting device can be optimized, thereby the double-layer doped phosphorescent light emitting device has a longer life.

For example, the method further comprises forming an electron transport layer 12, wherein the electron type host material is different from an electron transport material of the electron transport layer 12.

For example, if the electron type host material is different from the electron transport material of the electron transport layer 12, the life of the double-layer doped phosphorescent light emitting device can be optimized, thereby the double-layer doped phosphorescent light emitting device has a longer life.

For example, in the method, the selection of the host material and the guest material of the first light emitting layer 131 and the second light emitting layer 132, the selection of the material of the hole transport layer and the electron transport layer, the doping amount of the guest material, the thickness of the first light emitting layer 131 and the thickness of the second light emitting layer 132 refer to the above mentioned contents of the double-layer doped phosphorescent light emitting device.

A variety of double doped phosphorescent light emitting devices given above can be prepared through the above methods.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms "comprises," "comprising," "includes," "including," etc., are intended to specify that the elements or the objects stated before these terms encompass the elements or the objects and equivalents thereof listed after these terms, but do not preclude the other elements or objects.

It's to be noted that, the embodiments and the drawings of the present disclosure only give the content and the component related to the embodiments of the present disclosure, other contents and components that are not described refer to the conventional design. The doping content of the phosphorescent dopant in the embodiment of the present disclosure is the percentage of the quality. Each substance used in the embodiment of the present disclosure is a common material in the field, and the abbreviations or the full name of the material each abbreviation representing given in the brackets before or after the substance is facilitate to understanding.

At least one embodiment of the present disclosure provides a double-layer doped phosphorescent light emitting device and a fabrication method thereof. The double-layer doped phosphorescent light emitting device comprises a light emitting double-layer, wherein the light emitting double-layer comprises a first light emitting layer and a second light emitting layer, the first light emitting layer and the second light emitting layer each comprise a host material and a guest material, the host material of the first light emitting layer is a hole type host material and the host material of the second light emitting layer is an electron type host material. The problem of poor repeatability of the device caused by the fluctuation of the doping ratio of an independent co-host doping during the triple-source co-evaporation can be solved, and the limitation of the material selection in the pre-mixed double-host doping is avoided.

What are described above is related to the illustrative embodiments of the disclosure only and not limitative to the scope of the disclosure. In the technical scale disclosed in the present disclosure any technical persons who are familiar with the technical field of the present invention the changes or replacements easily to envisage should within the scope of the present disclosure. Therefore, the protection scope of the present disclosure should be based on the protection scope of the claim.

The present application claims the priority of the Chinese Patent Application No.201510276057.9 filed on May 26, 2015, which is incorporated herein by reference as part of the disclosure of the present application.

## Claims

1. A double-layer doped phosphorescent light emitting device, comprising a light emitting double-layer,
wherein the light emitting double-layer comprises a first light emitting layer and a second light emitting layer, the first light emitting layer and the second light emitting layer each comprise a host material and a guest material, the host material of the first light emitting layer is a hole type host material and the host material of the second light emitting layer is an electron type host material.

2. The double-layer doped phosphorescent light emitting device according to claim 1,
wherein a thickness of the first light emitting layer is determined by a hole mobility of the hole type host material, and a thickness of the second light emitting layer is determined by an electron mobility of the electron type host material.

3. The double-layer doped phosphorescent light emitting device according to claim 1 or 2, wherein the thickness of the first light emitting layer and the thickness of the second light emitting layer are different.

4. The double-layer doped phosphorescent light emitting device according to any one of claims 1 to 3, wherein a total thickness of the first light emitting layer and the second light emitting layer is from 20 to 40 nm.

5. The double-layer doped phosphorescent light emitting device according to any one of claims 1 to 4, further comprising a hole transport layer, wherein the hole type host material is different from a hole transport material of the hole transport layer.

6. The double-layer doped phosphorescent light emitting device according to claim 5,
wherein the host material of the first light emitting layer comprises a material containing a carbazole group, and the material containing a carbazole group comprises any one of 4,4'-Bis(N-carbazolyl)-1,1'-biphenyl (CBP), 4,4',4"-Tris(carbazol-9-yl)triphenylamine (TCTA) and 9,9-(1,3-Phenylene)bis-9H-carbazole (mCP), the hole transport material comprises any one of N,N'-diphenyl-N,N'-bis(1-naphthyl)-(1,1'-biphenyl)-4,4'-diamine (NPB), 4,4',4'-Tris(N-3-methylphenyl-N-phenyl-amino)-triphenylamine (m-MTDATA), or 4,4'-bis [N-(4-carbazolylphenyl)-N-phenylamino] biphenyl (CPB).

7. The double-layer doped phosphorescent light emitting device according to any one of claims 1 to 6, further comprising an electron transport layer, wherein the electron type host material is different from an electron transport material of the electron transport layer.

8. The double-layer doped phosphorescent light emitting device according to claim 7,
wherein the host material of the second light emitting layer comprises any one of aluminum (III) bis(2-methyl-8-quninolinato)-4-phenylphenolate (BAlq), 2,4,6-tri(9H-carbazol-9-yl)-1,3,5-triazine (TRZ) and 2,7-bis(diphenyl phosphine oxide)-9,9-dimethylfluorene (PO6), and the electron transport material comprises any one of 4,7-diphenyl-1,10-phenanthroline(BPhen), 1,3,5-Tris(1-phenyl- 1H-benzimidazol-2-yl)benzene (TPBI), or n-type doped electron transport material.

9. The double-layer doped phosphorescent light emitting device according to any one of claims 1 to 8, wherein the guest material of the first light emitting layer and the guest material of the second light emitting layer are a same phosphorescent dopant, and the phosphorescent dopant comprises any one of a red phosphorescent material and a green phosphorescent material.

10. The double-layer doped phosphorescent light emitting device according to claim 9,
wherein the red phosphorescent material comprises any one of platinum (II) octaethyl porphyrin (PtOEP), Bis[2-(2'-benzothienyl)pyridinato-N,C3'](acetylacetonato)iridium [(btp)₂Ir(acac)], Tris(dibenzoylmethane) mono(1,10-phenanthroline)europium(III) [Eu(dbm)₃(Phen)], Tris[1-phenylisoquinoline-C2,N] iridium(III) (Ir(piq)₃), or Bis(1 -phenylisoquinoline)(acetylacetonate)iridium(III) [Ir(piq)₂(acac)]; and
the green phosphorescent material comprises any one of Tris[1-phenylisoquinoline-C2,N] iridium(III) (Ir(piq)₃), acetylacetonato bis(2-phenylpyridine) Iridium [Ir(ppy)₂(acac)], Tris-(3-methyl-2-phenylpyridine) iridium (Ir(mppy)3), or acetylacetonato bis(2-(4-fluorophenyl)-4 -phenylpyridine) Iridium [Ir(FPP)₂(acac)], tri(4-tert-butyl-2-phenylpyridine) Iridium (Ir(Bu-ppy)₃).

11. A fabrication method of a double-layer doped phosphorescent light emitting device, comprising: forming a light emitting double-layer,
wherein the forming of the light emitting double-layer comprises forming a first light emitting layer and forming a second light emitting layer, the first light emitting layer and the second light emitting layer each comprise a host material and a guest material, the host material of the first light emitting layer is a hole type host material and the host material of the second light emitting layer is an electron type host material.

12. The fabrication method of the double-layer doped phosphorescent light emitting device according to claim 11, wherein both the first light emitting layer and the second light emitting layer are formed by double-sources co-evaporation.

13. The fabrication method of the double-layer doped phosphorescent light emitting device according to claim 11 or 12, wherein a thickness of the first light emitting layer and a thickness of the second light emitting layer are determined by a hole mobility of the hole type host material and an electron mobility of the electron type host material respectively.

14. The fabrication method of the double-layer doped phosphorescent light emitting device according to any one of claims 11 to 13, wherein excitons recombine at an interface of the first light emitting layer and the second light emitting layer by adjusting the thickness of the first light emitting layer and the thickness of the second light emitting layer.

15. The fabrication method of the double-layer doped phosphorescent light emitting device according to any one of claims 11 to 14, further comprising forming a hole transport layer, wherein the hole type host material is different from a hole transport material of the hole transport layer.

16. The fabrication method of the double-layer doped phosphorescent light emitting device according to claim 15, wherein the host material of the first light emitting layer comprises a material containing carbazole group, and the material containing carbazole group comprises any one of 4,4'-Bis(N-carbazolyl)-1,1-biphenyl (CBP), 4,4',4"-Tris(carbazol-9-yl)triphenylamine (TCTA) and 9,9-(1,3-Phenylene)bis-9H-carbazole (mCP), the hole transport material comprises any one of N,N'-bis(1-naphthyl)-N,N'-biphenyl-1,1'-biphenyl-4,4'-diamine (NPB), 4,4',4'-Tris(N-3-methylphenyl-N-phenyl-amino)-triphenylamine (m-MTDATA), or 4,4'-bis [N-(4-carbazolylphenyl)-N-phenylamino] biphenyl (CPB).

17. The fabrication method of the double-layer doped phosphorescent light emitting device according to any one of claims 11 to 16, further comprising forming an electron transport layer, wherein the electron type host material is different from an electron transport material of the electron transport layer.

18. The fabrication method of the double-layer doped phosphorescent light emitting device according to claim 17, wherein the host material of the second light emitting layer comprises any one of aluminum (III) bis(2-methyl-8-quninolinato)-4-phenylphenolate (BAlq), 2,4,6-tri(9H-carbazol-9-yl)-1,3,5-triazine (TRZ) and 2,7-bis(diphenyl phosphine oxide)-9,9-dimethylfluorene (PO6), and the electron transport material comprises any one of 4,7-diphenyl-1,10-phenanthroline(BPhen), 1,3,5-Tris(1-phenyl- 1H-benzimidazol-2-yl)benzene (TPBI), or n-type doped electron transport material.

19. The fabrication method of the double-layer doped phosphorescent light emitting device according to any one of claims 11 to 18, wherein the guest material of the first light emitting layer and the guest material of the second light emitting layer are a same phosphorescent dopant, and the phosphorescent dopant comprises any one of a red phosphorescent material and a green phosphorescent material.

20. The fabrication method of the double-layer doped phosphorescent light emitting device according to claim 19, wherein the red phosphorescent material comprises anyone of platinum (II) octaethyl porphyrin (PtOEP), Bis[2-(2'-benzothienyl)pyridinato-N,C3'](acetylacetonato)iridium [(btp)₂Ir(acac)], Tris(dibenzoylmethane) mono(1,10-phenanthroline)europium(III) [Eu(dbm)₃(Phen)], Tris[1-phenylisoquinoline-C2,N] iridium(III) (Ir(piq)₃), or Bis(1 -phenylisoquinoline)(acetylacetonate)iridium(III) [Ir(piq)₂(acac)]; and
the green phosphorescent material comprises any one of Tris[1-phenylisoquinoline-C2,N] iridium(III) (Ir(piq)₃), acetylacetonato bis(2-phenylpyridine) Iridium [Ir(ppy)₂(acac)], Tris-(3-methyl-2-phenylpyridine) iridium (Ir(mppy)3), acetylacetonato bis(2-(4-fluorophenyl)-4 -phenylpyridine) Iridium [Ir(FPP)₂(acac)], or tri(4-tert-butyl-2-phenylpyridine) Iridium (Ir (Bu-ppy)₃).
